(19) Europäisches Patentamt / European Patent Office / Office européen des brevets

(11) **EP 1 998 450 B1**

(12) **FASCICULE DE BREVET EUROPEEN**

(45) Date de publication et mention de la délivrance du brevet:
**04.04.2018 Bulletin 2018/14**

(51) Int Cl.:
*H03K 17/082* *(2006.01)*     *H03K 17/687* *(2006.01)*
*H03K 17/284* *(2006.01)*

(21) Numéro de dépôt: **08104045.3**

(22) Date de dépôt: **21.05.2008**

(54) **Système de commande et de protection d'une sortie d'un équipement d'automatisme**

Steuer- und Schutzsystem des Ausgangs einer Automatisierungsvorrichtung

Control and protection system for an output of automation equipment

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **01.06.2007 FR 0755398**

(43) Date de publication de la demande:
**03.12.2008 Bulletin 2008/49**

(73) Titulaire: **Schneider Electric Industries SAS
92500 Rueil-Malmaison (FR)**

(72) Inventeurs:
• **GOMEZ, Gérard
06150, LE BROC (FR)**
• **LACHENAL, Jean-Louis
06560, VALBONNE (FR)**
• **TONET, Richard
06650, LE ROURET (FR)**

(74) Mandataire: **Dufresne, Thierry et al
Schneider Electric Industries SAS
Service Propriété Industrielle
35 rue Joseph Monier - CS 30323
92506 Rueil-Malmaison Cedex (FR)**

(56) Documents cités:
**EP-A- 0 743 751**     **EP-A- 1 184 984**
**US-A- 4 918 564**     **US-B1- 6 184 669**

**Description**

La présente invention se rapporte à un système de commande et de protection électronique d'une voie de sortie d'un équipement d'automatisme, tel qu'un automate programmable industriel (ou PLC Programmable Logical Controller), en particulier une voie de sortie statique susceptible de piloter une charge électrique en fonction d'un signal numérique de commande issu de l'équipement d'automatisme.

Un automate programmable est un équipement d'automatisme capable de piloter, commander et/ou surveiller un ou plusieurs process, notamment dans le domaine des automatismes industriels, du bâtiment ou de la distribution électrique. Il comporte généralement une unité centrale et un certain de nombre de voies d'entrées et de voies de sorties. Lorsque l'automate programmable est de construction modulaire, ces entrées/sorties peuvent être groupées sur des modules d'entrées/ sorties comportant chacun par exemple 8, 16 ou 32 voies.

Les entrées permettent de recevoir des informations notamment en provenance de capteurs relatifs au process. L'unité centrale scrute d'abord les entrées, puis exécute un programme application (ou programme utilisateur) dans le but de piloter les sorties, lesquelles peuvent commander une charge électrique de type pré-actionneur, tel qu'une bobine d'excitation d'un appareil de commutation électromagnétique ou autres.

Les sorties statiques sont protégées contre les surcharges et les courts circuits par un système de protection électronique qui permet la disjonction de la sortie en cas de défaut. Généralement, la valeur du courant de disjonction est dimensionnée pour se déclencher à partir d'environ 1,25 fois la valeur du courant maximum spécifié, c'est-à-dire 125mA pour les sorties de courant nominal 100mA et 625mA pour les sorties 500mA.

Or, cette valeur de courant de disjonction peut s'avérer pénalisante dans certains cas, en particulier pour des voies de sorties commandant des pré-actionneurs de type charge capacitive ou lampe à filament. En effet, il est connu que dans le cas d'une lampe à filament par exemple, la résistance de la lampe varie beaucoup en fonction de la température du filament, ce qui entraîne une forte variation du courant qui traverse la lampe en fonction de la température du filament. Lorsque la température du filament est basse, par exemple à température ambiante au moment de l'allumage, la résistance du filament est faible et le courant qui traverse la lampe est donc très élevé. La température du filament augmente ensuite rapidement et se stabilise, ce qui augmente rapidement sa résistance et ce qui diminue donc le courant.

Ainsi, on considère que la valeur initiale du courant de pointe susceptible de traverser la lampe pendant cette phase de démarrage peut ainsi atteindre cinq fois le courant nominal (par exemple 500 mA pour une sortie 24Vdc de courant nominal 100mA) et que le courant circulant dans la lampe ne se stabilise à sa valeur nominale qu'après environ 10ms. Un tel comportement peut aussi se rencontrer au démarrage pour des charges capacitives. Il est alors évident qu'un système classique de protection d'une voie de sortie déclenchera alors sur disjonction.

Les documents US4918564, EP0743751, EP1184984 et US6184669 décrivent déjà des circuits électroniques de commande et de protection de transistors de sortie contre des surintensités.

L'invention a donc pour but d'éviter une disjonction intempestive d'une voie de sortie statique à transistor pendant cette phase de démarrage et de stabilisation du courant, tout en garantissant son immunité à la puissance engendrée par l'augmentation du courant qui la traverse et donc sa dégradation, voire sa destruction.

L'invention a également pour but de limiter le courant de pointe durant le temps de stabilisation, de façon à éviter ainsi la nécessité de sur-dimensionner de l'organe de commutation statique de la sortie (tel qu'un transistor) pour pouvoir absorber le courant de pointe initial au démarrage.

Pour cela, l'invention décrit un système de commande et de protection électronique d'une voie de sortie d'un équipement d'automatisme, la voie de sortie étant susceptible de piloter une charge électrique en fonction d'un signal de commande issu de l'équipement d'automatisme. Le système comporte : i) un dispositif de commutation de la charge électrique comprenant un transistor MOS de commutation dont la source est reliée à une borne de tension positive au travers d'une résistance et dont le drain est relié à la charge, le transistor de commutation étant commutable entre un état passant dans lequel la charge est reliée à ladite résistance et un état bloqué, ii) un dispositif de limitation limitant la tension aux bornes de ladite résistance à une valeur maximale prédéterminée, iii) un dispositif de disjonction de la voie de sortie capable de commuter le transistor de commutation à l'état bloqué lorsque le courant traversant ladite résistance dépasse un seuil prédéterminé pendant une durée prédéterminée.

Selon l'invention, le dispositif de limitation comporte un transistor bipolaire dont l'émetteur est relié à la source du transistor de commutation et dont le collecteur est utilisé pour commander la grille du transistor de commutation, et comporte un élément de chute de tension relié entre la borne de tension positive et la base dudit transistor bipolaire, la chute de tension aux bornes de l'élément étant égale à la somme de la tension base-émetteur dudit transistor bipolaire et de la valeur de la tension aux bornes de ladite résistance, ladite chute de tension aux bornes de l'élément de chute de tension étant déterminée afin de pouvoir limiter dans tous les cas la tension aux bornes de ladite résistance à la valeur maximale prédéterminée. Selon une caractéristique, le dispositif de disjonction comprend un module comparateur entre la tension base-émetteur dudit transistor bipolaire et une tension de référence, la sortie du module comparateur étant reliée à un module temporisateur, dont la sortie est reliée à la grille d'un transistor MOS de disjonction.

L'invention concerne également un équipement d'automatisme comprenant une unité centrale et au moins une voie de sortie, l'unité centrale étant susceptible de générer un signal de commande durant l'exécution d'un programme de commande et/ou de surveillance pour commuter ladite voie de sortie, l'équipement d'automatisme comportant un tel système de commande et de protection électronique de ladite voie de sortie.

D'autres caractéristiques et avantages vont apparaître dans la description détaillée qui suit en se référant à un mode de réalisation donné à titre d'exemple et représenté par les dessins annexés sur lesquels :

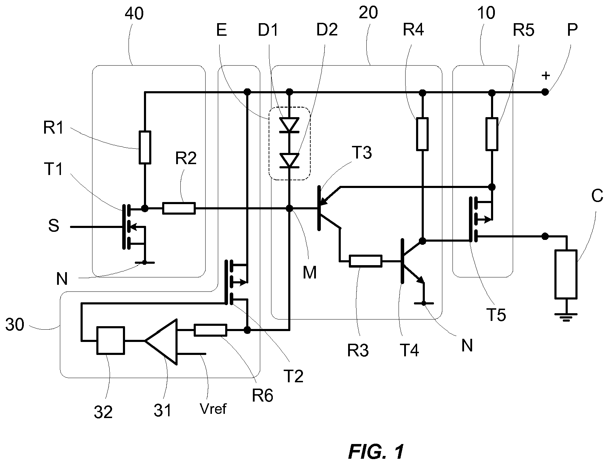

- la figure 1 représente un exemple de schéma d'un système de commande et de protection électronique d'une voie de sortie conforme à l'invention.

En référence à la figure 1, une charge électrique extérieure C est susceptible d'être commandée à partir d'un signal numérique de commande S d'une voie de sortie d'un équipement d'automatisme tel qu'un automate programmable. Le signal de commande S est généré par l'unité centrale de l'automate programmable suite par exemple à l'exécution d'un programme application. De façon classique, lorsque le signal de commande S vaut 1, alors la charge électrique C est connectée entre une borne P de tension positive, telle qu'une tension 24 Vdc, et la masse (ou point 0 de cette tension) ce qui fait que la charge C est alimentée. Inversement, lorsque le signal de commande S vaut 0, la charge électrique C n'est plus connectée à la borne de tension positive P et n'est donc plus alimentée. Un système de commande et de protection électronique est destiné à commander le circuit électronique de sortie et à le protéger contre un défaut de surcharge et/ou de court-circuit de la charge C.

Le système de commande et de protection électronique comporte un dispositif de commutation statique 10 permettant de commander la charge électrique C, un dispositif de limitation 20 permettant de limiter le courant circulant dans le dispositif de commutation statique 10 et un dispositif de disjonction 30 permettant en cas de défaut de couper la commande du dispositif de commutation statique 10.

Le dispositif de commutation 10 comporte un transistor de commutation T5 de type MOS canal P dont le drain est connecté à la charge C et dont la source est connectée à la borne de tension positive P via une résistance de charge R5.

Le dispositif de limitation 20 limite la tension aux bornes de la résistance de charge R5 à une valeur maximale prédéterminée, de façon à limiter le courant maximum traversant la résistance R5 et donc le courant traversant le transistor de commutation T5. Il comporte un transistor T3 de type bipolaire PNP, un transistor T4 de type bipolaire NPN et un élément E de chute de tension. L'émetteur du transistor T3 est relié à la source du transistor T5. Le collecteur du transistor T3 est relié à la base du transistor T4 via une résistance R3. Le collecteur du transistor T4 est relié à la borne positive P via une résistance R4 ainsi qu'à la grille du transistor T5. L'émetteur du transistor T4 est relié à une borne de tension négative N du circuit électronique (par exemple 19 Vdc de façon à obtenir 5 Vdc entre les bornes P et N).

La base du transistor T3 forme le point M qui est relié à la source de tension positive P via l'élément E de chute de tension. Dans le mode de réalisation de la figure 1, l'élément E est composé de deux diodes D1 et D2 reliées en série entre le point M et la borne positive P. Les cathodes des diodes D1 et D2 sont dirigées vers le point M et les anodes vers la borne positive P.

Le dispositif de disjonction 30 comporte un transistor de disjonction T2 de type MOS canal P dont le drain est relié au point M et dont la source est reliée à la borne positive P. Le dispositif de disjonction 30 comporte également un module comparateur 31 et un module temporisateur 32. Le module comparateur 31 possède une première entrée reliée au point M via une résistance R6 et une seconde entrée recevant une tension de référence Vref. La sortie du module comparateur 31 est reliée à l'entrée du module temporisateur 32 et la sortie du module temporisateur 32 est reliée à la grille du transistor T2.

Par ailleurs, le système de commande et de protection comprend également un dispositif de commande 40 comportant un transistor T1 de type MOS canal N. La grille du transistor T1 est reliée au signal de commande S. La source du transistor T1 est reliée à la borne négative N du circuit électronique. Le drain du transistor T1 est relié au point M via une résistance R2 ainsi qu'à la borne positive P via une résistance R1. La valeur de la résistance R2 est très élevée pour que le courant de chute de R2 soit négligeable.

Le fonctionnement normal du système est le suivant :

- Au départ, le signal de commande S est égal à 0, donc le transistor T1 est à l'état bloqué (ouvert). La base du transistor T3 est alors reliée à la borne positive P via R1 et R2. Donc le transistor T3 est bloqué et le transistor T4 est également bloqué. Comme la grille du transistor de commutation T5 est alors reliée à la borne positive P via R4, cela entraîne que le transistor de commutation T5 est à l'état bloqué et la charge électrique C n'est pas alimentée : la sortie n'est pas commandée.
- Quand le signal de commande S passe à 1, le transistor T1 devient passant (fermé). La base du transistor T3 se retrouve alors reliée à la borne négative N via la résistance R2. Malgré le fait que la valeur de R2 soit très élevée, le transistor T3 devient passant. La base du transistor T4 se retrouve donc reliée à la borne positive P via les résistances R3 et R5 et T4 va être passant. Comme la grille du transistor de commutation T5 est alors reliée à la borne négative N, cela entraîne que le transistor de commutation T5 est à l'état passant, la charge électrique C est reliée à la borne positive P via la résistance R5 et est donc alimentée : la sortie est commandée.

La chute de tension $V_E$ aux bornes de l'élément E est égale à : $V_E = V_{BET3} + V_{R5}$, dans lequel $V_{BET3}$ représente la tension Base-Emetteur du transistor T3 et $V_{R5}$ représente la tension aux bornes de la résistance R5. Quand le transistor T3 est passant et saturé, c'est-à-dire quand la sortie est commandée, la chute de tension $V_{BET3}$ entre Base et Emetteur est fixe et égale à environ 0,6 V.

Selon l'invention, l'élément de chute de tension E est choisi pour fournir une chute de tension $V_E$ déterminée afin de pouvoir limiter dans tous les cas la tension $V_{R5}$ à la valeur $V_{R5max}$. Dans le mode de réalisation présenté, l'élément E est composé des deux diodes D1 et D2 qui fournissent chacune une chute de tension $V_{D1}$ et $V_{D2}$ constante égale à environ 0,6 V, ce qui correspond à une valeur usuelle pour ce genre de composant. On obtient donc une limitation de la valeur de la tension $V_{R5}$ :

$$V_{R5max} = V_E - V_{BET3} = V_{D1} + V_{D2} - V_{BET3} = V_{D1} = 0,6 \text{ V}$$

Le courant maximal circulant dans la résistance R5 est égal à : $I_{R5max} = V_{R5max} / R5 = V_{D1} / R5$. Comme $V_{D1}$ et R5 sont déterminés, on peut ainsi pendant un certain temps limiter le courant $I_{R5}$ traversant R5 et donc le courant traversant le transistor de commutation T5, même en cas de court-circuit. Le transistor T5 n'a ainsi pas besoin d'être dimensionné de façon trop importante, ce qui constitue un gros avantage en terme de dissipation thermique et d'implantation de la voie de sortie dans un module d'entrées/sorties de l'automate programmable, pour pouvoir installer par exemple 32 voies de sortie sur un seul module, chaque voie étant équipé d'un système de commande et de protection électronique conforme à l'invention.

En effet, lorsque la charge C est en court-circuit, alors la tension $V_{DST5}$ entre la source et le drain du transistor T5 est sensiblement égale à : $V_{DST5} = 24 - V_{R5max}$, dans le cas où la tension positive est 24 Vdc. Le transistor T5 doit alors juste être capable de supporter la puissance $P_{max}$ suivante pendant la durée de la temporisation, à savoir : $P_{max} = V_{DST5} * I_{R5max}$, c'est-à-dire : $Pmax = (24 - V_{R5max}) * V_{D1} / R5$.

A titre d'exemple, pour des sorties 24 Vdc à courant nominal égal à 100 mA, on peut choisir une résistance R5 égale à 2,2 Ohms (2R2), ce qui donne un courant $I_{R5max}$ égal à 270 mA. Pour des sorties 500 mA, la résistance R5 peut être égale à 0,4 Ohms.

Lorsque la sortie fonctionne normalement et n'est pas en court-circuit, le point M (qui correspond à la base du transistor T3) est au potentiel suivant $V_{M1} = 24 - V_{BET3} - V_{R5}$, dans lequel $V_{R5}$ a une valeur faible, car le courant consommé par la sortie est le courant nominal. Par contre, lorsque la sortie est en court-circuit, le point M est alors au potentiel suivant $V_{M2} = 24 - V_{BET3} - V_{R5max}$, avec $V_{R5max} = V_{D1} = 0,6$ V.

Le point M est connecté à la première entrée du module comparateur 31, via une résistance R6. Il n'est pas utile de prendre en compte la résistance R6 car la valeur de cette résistance R6 est très faible et l'impédance d'entrée du comparateur 31 est très grande. Une tension de référence $V_{ref}$ est appliquée sur la seconde entrée du comparateur 31. Cette tension de référence $V_{ref}$ est choisie entre les valeurs $V_{M1}$ et $V_{M2}$, de façon à ce que le module comparateur 31 puisse détecter un court-circuit de la sortie. Ainsi, en fonctionnement normal, la valeur $V_{M1}$ est inférieure à la tension de référence $V_{ref}$ et la sortie du comparateur vaut zéro. En cas de court-circuit, la valeur $V_{M2}$ devient supérieure à $V_{ref}$ et la sortie du comparateur vaut 1. Pour augmenter la précision du seuil de disjonction et la rendre indépendante de la température, la tension de référence $V_{ref}$ est de préférence réalisée à l'aide d'une tension Base-Emetteur d'un autre transistor bipolaire appairé au transistor T3.

La sortie du module comparateur 31 enclenche alors le module temporisateur 32, dont la durée est prédéterminée pour être capable de laisser passer les court-circuits temporaires pouvant survenir au démarrage de certaines sorties, par exemple de l'ordre de 10 ms. Si le court-circuit est toujours présent en fin de temporisation, alors le module temporisateur 32 bascule et la grille du transistor T2 est commandée, ce qui a pour effet de relier directement le point M avec la borne positive P. La base de T3 est alors reliée à la borne positive P ce qui a pour effet de bloquer le transistor T3 et donc de passer le transistor T5 à l'état bloqué. La sortie n'est plus commandée.

Ainsi, en cas de surcharge ou de court-circuit, le système de commande et de protection est capable de couper la sortie au bout de la durée prédéterminée dans le module temporisateur 32, en cas de dépassement de la tension aux bornes de la résistance de charge R5 au-delà d'un seuil prédéterminé par la tension de référence $V_{ref}$. De plus, pendant cette durée prédéterminée, le système est capable de limiter le courant traversant le transistor de commutation T5 et la résistance de charge R5 à un courant maximal $I_{R5max}$ calculé à partir de la chute de tension de l'élément E.

On pourrait trouver d'autres solutions équivalentes pour réaliser l'élément de chute de tension E. Par exemple, il est possible de remplacer une ou chaque diode D1 et/ou D2 de l'élément E par un transistor bipolaire PNP du même type que T3 et appairé à T3, dont la chute de tension est similaire à celle d'une diode. Ce transistor bipolaire serait alors connecté de la façon suivante : Emetteur du transistor à la place de l'Anode de la diode, et Collecteur + Base à la place de la Cathode de la diode. On pourrait aussi remplacer l'ensemble des 2 diodes par un montage Darlington ou même par une seule diode Zéner de chute égale à environ 1,3 V, bien que la chute de tension fournie par une Zéner soit moins précise.

Par ailleurs, les dérives en température des chutes de tension des diodes et des tensions Base-Emetteur des transistors bipolaires sont équivalentes. Donc, cela garantit avantageusement que le système continue à fonctionner de la même façon même en cas d'élévation de la température (par exemple 80°C).

Il est bien entendu que l'on peut, sans sortir du cadre de l'invention, imaginer d'autres variantes et perfectionnements de détail et de même envisager l'emploi de moyens équivalents.

## Revendications

1. Système de commande et de protection électronique d'une voie de sortie d'un équipement d'automatisme, la voie de sortie étant susceptible de piloter une charge électrique (C) en fonction d'un signal de commande (S) issu de l'équipement d'automatisme, le système de commande et de protection comportant :

   - un dispositif de commutation (10) de la charge électrique comprenant un transistor MOS de commutation (T5) dont la source est reliée à une borne de tension positive (P) au travers d'une résistance (R5) et dont le drain est relié à la charge électrique (C), le transistor de commutation (T5) étant commutable entre un état passant dans lequel la charge électrique (C) est reliée à ladite résistance (R5) et un état bloqué,
   - un dispositif de limitation (20) limitant la tension aux bornes de ladite résistance (R5) à une valeur maximale prédéterminée ($V_{R5max}$),
   - un dispositif de disjonction (30) de la voie de sortie capable de commuter le transistor de commutation (T5) à l'état bloqué lorsque le courant traversant ladite résistance (R5) dépasse un seuil prédéterminé pendant une durée prédéterminée,

   **caractérisé en ce que** le dispositif de limitation (20) comporte :

   - un transistor bipolaire (T3) dont l'émetteur est relié à la source du transistor de commutation (T5) et dont le collecteur est utilisé pour commander la grille du transistor de commutation (T5),
   - un élément (E) de chute de tension relié entre la borne de tension positive (P) et la base dudit transistor bipolaire (T3), la chute de tension aux bornes de l'élément (E) étant égale à la somme de la tension base-émetteur ($V_{BET3}$) dudit transistor bipolaire (T3) et de la valeur de la tension ($V_{R5max}$) aux bornes de ladite résistance (R5),

   ladite chute de tension aux bornes de l'élément de chute de tension étant déterminée afin de pouvoir limiter dans tous les cas la tension aux bornes de ladite résistance à la valeur maximale prédéterminée.

2. Système de commande et de protection selon la revendication 1, **caractérisé en ce que** l'élément de chute de tension (E) comporte deux diodes (D1, D2) en série dont les anodes sont placées du côté de la borne de tension positive (P).

3. Système de commande et de protection selon la revendication 1, **caractérisé en ce que** l'élément de chute de tension (E) comporte une diode Zener dont l'anode est placée du côté de la borne de tension positive.

4. Système de commande et de protection selon la revendication 1, **caractérisé en ce que** l'élément de chute de tension (E) comporte deux transistors bipolaires en montage Darlington.

5. Système de commande et de protection selon la revendication 1, **caractérisé en ce que** le dispositif de disjonction (30) comprend un module comparateur (31) entre la tension base-émetteur ($V_{BET3}$) dudit transistor bipolaire (T3) et une tension de référence ($V_{ref}$), la sortie du module comparateur (31) étant reliée à un module temporisateur (32).

6. Système de commande et de protection selon la revendication 5, **caractérisé en ce que** le dispositif de disjonction (30) comprend un transistor MOS de disjonction (T2) dont la grille est reliée à une sortie du module temporisateur (32), dont la source est reliée à la borne positive (P) et dont le drain est relié à la base du transistor bipolaire (T3).

7. Système de commande et de protection selon la revendication 1, **caractérisé en ce qu'**il comporte également un transistor de commande (T1) dont la grille est reliée au signal numérique de commande (S), dont la source est reliée à une borne de tension négative (N) et dont le drain est relié à la borne de tension positive (P) via une résistance (R1) et à la base du transistor bipolaire (T3) via une résistance (R2).

8.  Equipement d'automatisme comprenant une unité centrale et au moins une voie de sortie, l'unité centrale étant susceptible de générer un signal de commande (S) durant l'exécution d'un programme de commande et/ou de surveillance pour commuter ladite voie de sortie, **caractérisé en ce que** l'équipement d'automatisme comporte un système de commande et de protection électronique de ladite voie de sortie selon l'une des revendications précédentes.

**Patentansprüche**

1.  Elektronisches Steuer- und Schutzsystem eines Ausgangskanals einer Automatisierungsausrüstung, wobei der Ausgangskanal eine elektrische Last (C) abhängig von einem von der Automatisierungsausrüstung stammenden Steuersignal (S) steuern kann, wobei das Steuer- und Schutzsystem aufweist:

    - eine Schaltvorrichtung (10) der elektrischen Last, die einen MOS-Schalttransistor (T5) enthält, dessen Source über einen Widerstand (R5) mit einer positiven Spannungsklemme (P) verbunden ist, und dessen Drain mit der elektrischen Last (C) verbunden ist, wobei der Schalttransistor (T5) zwischen einem leitenden Zustand, in dem die elektrische Last (C) mit dem Widerstand (R5) verbunden ist, und einem blockierten Zustand umgeschaltet werden kann,
    - eine Begrenzungsvorrichtung (20), die die Spannung an den Klemmen des Widerstands (R5) auf einen vorbestimmten maximalen Wert ($V_{R5max}$) begrenzt,
    - eine Trennvorrichtung (30) des Ausgangskanals, die den Schalttransistor (T5) in den blockierten Zustand schalten kann, wenn der den Widerstand (R5) durchquerende Strom während einer vorbestimmten Dauer eine vorbestimmte Schwelle überschreitet,

    **dadurch gekennzeichnet, dass** die Begrenzungsvorrichtung (20) aufweist:

    - einen bipolaren Transistor (T3), dessen Emitter mit der Source des Schalttransistors (T5) verbunden ist, und dessen Kollektor verwendet wird, um das Gate des Schalttransistors (T5) zu steuern,
    - ein Spannungsabfallelement (E), das zwischen der positiven Spannungsklemme (P) und der Basis des bipolaren Transistors (T3) verbunden ist, wobei der Spannungsabfall an den Klemmen des Elements (E) gleich der Summe der Basis-Emitter-Spannung ($V_{BET3}$) des bipolaren Transistors (T3) und des Werts der Spannung ($V_{R5max}$) an den Klemmen des Widerstands (R5) ist,

    wobei der Spannungsabfall an den Klemmen des Spannungsabfallelements so bestimmt wird, dass in allen Fällen die Spannung an den Klemmen des Widerstands auf den vorbestimmten maximalen Wert begrenzt werden kann.

2.  Steuer- und Schutzsystem nach Anspruch 1, **dadurch gekennzeichnet, dass** das Spannungsabfallelement (E) zwei Dioden (D1, D2) in Reihe aufweist, deren Anoden auf der Seite der positiven Spannungsklemme (P) angeordnet sind.

3.  Steuer- und Schutzsystem nach Anspruch 1, **dadurch gekennzeichnet, dass** das Spannungsabfallelement (E) eine Zener-Diode aufweist, deren Anode auf der Seite der positiven Spannungsklemme angeordnet ist.

4.  Steuer- und Schutzsystem nach Anspruch 1, **dadurch gekennzeichnet, dass** das Spannungsabfallelement (E) zwei bipolare Transistoren in Darlington-Schaltung aufweist.

5.  Steuer- und Schutzsystem nach Anspruch 1, **dadurch gekennzeichnet, dass** die Trennvorrichtung (30) ein Komparatormodul (31) zwischen der Basis-Emitter-Spannung ($V_{BET3}$) des bipolaren Transistors (T3) und einer Bezugsspannung ($V_{ref}$) enthält, wobei der Ausgang des Komparatormoduls (31) mit einem Verzögerungsmodul (32) verbunden ist.

6.  Steuer- und Schutzsystem nach Anspruch 5, **dadurch gekennzeichnet, dass** die Trennvorrichtung (30) einen MOS-Trenntransistor (T2) enthält, dessen Gate mit einem Ausgang des Verzögerungsmoduls (32) verbunden ist, dessen Source mit der positiven Klemme (P) verbunden ist, und dessen Drain mit der Basis des bipolaren Transistors (T3) verbunden ist.

7. Steuer- und Schutzsystem nach Anspruch 1, **dadurch gekennzeichnet, dass** es ebenfalls einen Steuertransistor (T1) aufweist, dessen Gate mit dem digitalen Steuersignal (S) verbunden ist, dessen Source mit einer negativen Spannungsklemme (N) verbunden ist, und dessen Drain mit der positiven Spannungsklemme (P) über einen Widerstand (R1) und mit der Basis des bipolaren Transistors (T3) über einen Widerstand (R2) verbunden ist.

8. Automatisierungsausrüstung, die eine zentrale Einheit und mindestens einen Ausgangskanal enthält, wobei die zentrale Einheit während der Ausführung eines Steuer- und/oder Überwachungsprogramms ein Steuersignal (S) erzeugen kann, um den Ausgangskanal umzuschalten, **dadurch gekennzeichnet, dass** die Automatisierungsausrüstung ein elektronisches Steuer- und Schutzsystem des Ausgangskanals nach einem der vorhergehenden Ansprüche aufweist.

**Claims**

1. Electronic control and protection system for an output channel of automation equipment, the output channel being capable of controlling an electrical load (C) as a function of a control signal (S) from the automation equipment, the control and protection system comprising:

   - a device for switching (10) the electrical load comprising an MOS switching transistor (T5), the source of which is connected to a positive voltage terminal (P) via a resistor (R5) and the drain of which is connected to the electrical load (C), the switching transistor (T5) being switchable between an on-state in which the electrical load (C) is connected to said resistor (R5) and an off-state;
   - a limiting device (20) limiting the voltage at the terminals of said resistor (R5) to a predetermined maximum value ($V_{R5max}$);
   - an output channel cut-off device (30) able to switch the switching transistor (T5) to the off-state when the current flowing through said resistor (R5) passes a predetermined threshold for a predetermined duration,

   **characterized in that** the limiting device (20) comprises:

   - a bipolar transistor (T3), the emitter of which is connected to the source of the switching transistor (T5) and the collector of which is used to control the gate of the switching transistor (T5);
   - a voltage-drop element (E) connected between the positive voltage terminal (P) and the base of said bipolar transistor (T3), the voltage drop at the terminals of the element (E) being equal to the sum of the base-emitter voltage ($V_{BET3}$) of said bipolar transistor (T3) and the voltage value ($V_{R5max}$) at the terminals of said resistor (R5), said voltage drop at the terminals of the voltage-drop element being determined so as to be able, in all cases, to limit the voltage at the terminals of said resistor to the predetermined maximum value.

2. Control and protection system according to Claim 1, **characterized in that** the voltage-drop element (E) comprises two diodes (D1, D2) in series, the anodes of which are positioned on the side of the positive voltage terminal (P).

3. Control and protection system according to Claim 1, **characterized in that** the voltage-drop element (E) comprises a Zener diode, the anode of which is positioned on the side of the positive voltage terminal.

4. Control and protection system according to Claim 1, **characterized in that** the voltage-drop element (E) comprises two bipolar transistors in a Darlington connection.

5. Control and protection system according to Claim 1, **characterized in that** the cut-off device (30) comprises a comparison module (31) between the base-emitter voltage ($V_{BET3}$) of said bipolar transistor (T3) and a reference voltage ($V_{ref}$), the output of the comparison module (31) being connected to a timer module (32).

6. Control and protection system according to Claim 5, **characterized in that** the cut-off device (30) comprises a cut-off MOS transistor (T2), the gate of which is connected to an output of the timer module (32), the source of which is connected to the positive terminal (P), and the drain of which is connected to the base of the bipolar transistor (T3).

7. Control and protection system according to Claim 1, **characterized in that** it also comprises a control transistor (T1), the gate of which is connected to the numerical control signal (S), the source of which is connected to a negative voltage terminal (N), and the drain of which is connected to the positive voltage terminal (P) via a resistor (R1) and to the base of the bipolar transistor (T3) via a resistor (R2).

8. Automation equipment comprising a central unit and at least one output channel, the central unit being capable of generating a control signal (S) during the execution of a control and/or monitoring program in order to switch said output channel, **characterized in that** the automation equipment comprises an electronic control and protection system for said output channel according to one of the preceding claims.

*FIG. 1*

**EP 1 998 450 B1**

**RÉFÉRENCES CITÉES DANS LA DESCRIPTION**

**Documents brevets cités dans la description**

- US 4918564 A
- EP 0743751 A
- EP 1184984 A
- US 6184669 B